# EUROPEAN PATENT APPLICATION

(11) **EP 1 619 718 A1**
(43) Date of publication of application: **25.01.2006**
(21) Application number: 04726313.2
(22) Date of filing: 07.04.2004
(51) Int. Cl.: H01L 21/768, H01L 21/316, H01L 21/027

(54) **ELECTRONIC DEVICE AND ITS MANUFACTURING METHOD**

(30) Priority: 08.04.2003 JP 2003104499
(71) Applicant: MATSUSHITA ELECTRIC INDUSTRIAL CO., LTD., Kadoma-shi, Osaka 571-8501 (JP); Renesas Technology Corp., Tokyo 100-6334 (JP)
(72) Inventor: Matsumoto, Susumu, Takatsuki-shi, Osaka 569-1032 (JP); Sekiguchi, Mitsuru, Moriyama-shi, Shiga 524-0043 (JP); Nishioka, Yasutaka, c/o Renesas Technology Corp., Tokyo 100-6334 (JP); Tomita, Kazuo, c/o Renesas Technology Corp., Tokyo 100-6334 (JP); Iwasaki, Akihisa, Takatsuki-shi, Osaka 569-1121 (JP); Hashimoto, Keiji, c/o Renesas Technology Corp., Tokyo 100-6334 (JP)
(74) Representative: Grünecker, Kinkeldey, Stockmair & Schwanhäusser Anwaltssozietät
(86) International application number: PCT/JP2004/005044
(87) International publication number: WO 2004/090974

(57) **Abstract**

A first nitrogen-containing insulating film is formed under a low dielectric constant film, in which a via hole is formed, with a first nitrogen-non-containing insulating film interposed between the first nitrogen-containing insulating film and the low dielectric constant film. A second nitrogen-containing insulating film is formed over the low dielectric constant film with a second nitrogen-non-containing insulating film interposed therebetween.

## Description

### TECHNICAL FIELD

The present invention relates to electronic devices and methods for fabricating the same, and more particularly relates to techniques for forming interconnects.

### BACKGROUND ART

As the number of devices integrated on a single integrated circuit has been increasing these days, spaces between interconnects have become narrower, causing electric parasitic capacitance occurring between those interconnects to be increased. On the other hand, the line-to-line electric parasitic capacitance has to be reduced in the integrated circuit, which is required to operate at higher speed.

In order to lower the line-to-line electric parasitic capacitance, methods for reducing the relative dielectric constant of an insulating film provided between the interconnects have been considered. Proposed as a technique that provides the largest reduction in the line-to-line electric parasitic capacitance is, for example, to use, as the insulating film between the interconnects, a film (i.e., a low dielectric constant film) made of material whose dielectric constant is lower than that of a silicon oxide film. The examples of the low dielectric constant film include a carbon-containing silicon oxide film and a porous film, for example. Carbon-containing silicon oxide films contain carbon in the form of a bulky alkyl or phenyl group. The density (which is from about 1.0 to about 1.3 g/cm³) of a carbon-containing silicon oxide film is thus lower than the density (which is about 2.3 g/cm³) of a silicon oxide film, and the relative dielectric constant (which is from about 2.0 to about 3.0) of the carbon-containing silicon oxide film is also lower than the relative dielectric constant (which is from about 3.9 to about 4.3) of the silicon oxide film.

Since the film density of a low dielectric constant film, such as a carbon-containing silicon oxide film, is lower than that of a conventional insulating film, e.g., a silicon oxide film, provided between interconnects, the low dielectric constant film, when exposed to the air, is likely to absorb nitrogen or the like present in the air. Consequently, when a photolithography process for forming a trench pattern for upper-level metal interconnects is performed on the carbon-containing silicon oxide film with a via hole formed therein, for example, the following problem occurs. The photoresist applied cannot be developed sufficiently where it is located near the via hole, which causes the unnecessary photoresist around the via hole to remain. The desired trench pattern thus cannot be formed. This problem occurs for the following reasons. An amine present in the carbon-containing silicon oxide film with the via hole formed therein, or a basic material or the like derived from nitrogen present in a silicon carbon nitride film formed under the carbon-containing silicon oxide film diffuses through the via hole into the photoresist (which is a chemically amplified resist) on the carbon-containing silicon oxide film. As a result, the base concentration in the resist increases to neutralize an acid generated from an acid-generating material in the resist when the resist is exposed to light applied for the trench pattern formation. This prevents continuous acid-generating reaction from proceeding in the resist, which is an acrylic-based resist, for example, resulting in the insufficient development. This phenomenon is called resist poisoning. In the case of resist poisoning, lower-level and upper-level metal interconnects, e.g., are not properly connected to each other, that is, an interconnection failure occurs.

To address this problem, a non-patent related document 1 (See pp. 39-41 in "Proceedings of the 2002 International Interconnect Technology Conference" by M. Fayolle et al.) disclosed an interconnection structure for preventing resist poisoning and a method for fabricating the interconnection structure.

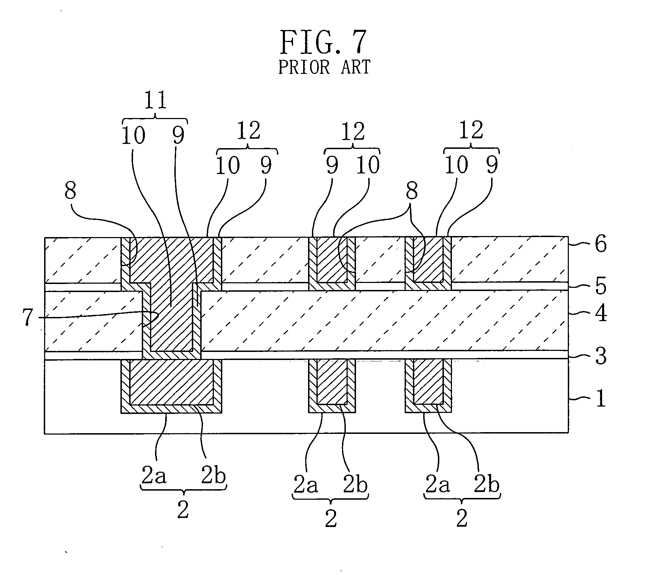

FIG. **7** is a cross sectional view illustrating the interconnection structure in a conventional electronic device, disclosed in the non-patent related document **1**.

As shown in FIG. **7**, lower-level metal interconnects **2** are formed in a first insulating film **1** formed on a silicon substrate (not shown). Each lower-level metal interconnect **2** is formed of a barrier metal film **2a** and a copper film **2b**, and the first insulating film **1** is formed of a silicon oxide film. On the lower-level metal interconnects **2** and the first insulating film **1**, a second insulating film **3** made of a silicon carbide film is formed. On the second insulating film **3**, a third insulating film **4** made of a carbon-containing silicon oxide film is formed. On the third insulating film **4**, a fourth insulating film **5** made of a silicon carbide film is formed. On the fourth insulating film **5**, a fifth insulating film **6** made of a carbon-containing silicon oxide film is formed. A via hole 7, which reaches at least one of the lower-level metal interconnects **2**, is formed in the second and third insulating films **3** and **4**, while a trench for wiring **8**, which reaches the via hole **7**, is formed in the fourth and fifth insulating films **5** and **6**. In the via hole **7** and the trench **8**, a barrier metal film **9** and a copper film **10** are formed in sequence to form a via plug **11** and upper-level metal interconnects **12**. The via plug **11** connects the lower-level metal interconnects **2** and the upper-level metal interconnects **12**.

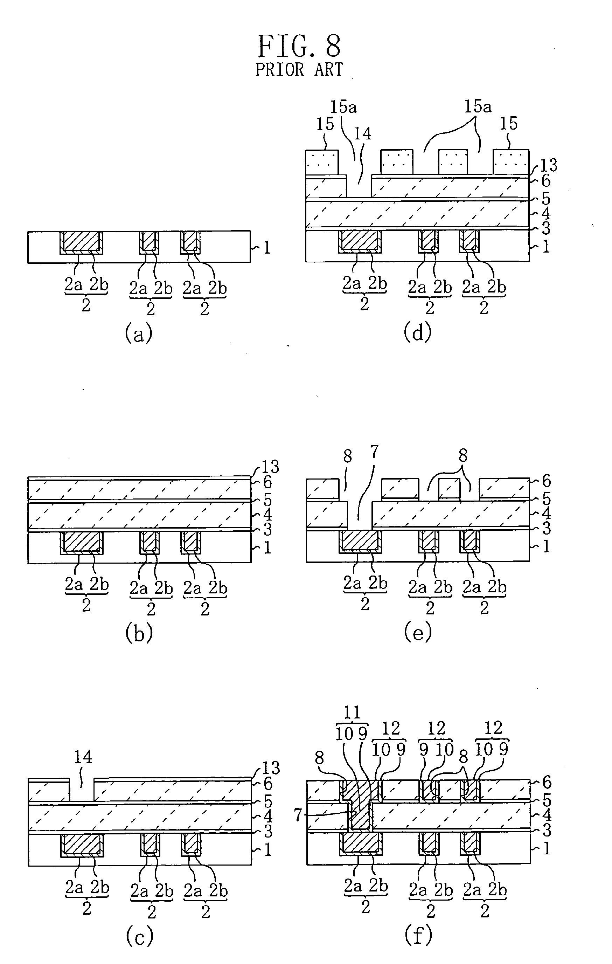

FIGS. **8(a)** through **8(f)** are cross sectional views indicating process steps of a method for fabricating the conventional electronic device disclosed in the non-patent related document 1, that is, a method for fabricating the electronic device shown in FIG. 7.

First, as shown in FIG. **8(a)**, a first insulating film **1** is formed on a silicon substrate (not shown), after which lower-level metal interconnects **2**, formed of a barrier metal film **2a** and a copper film **2b**, are buried in the first insulating film **1**.

Next, as shown in FIG. **8(b)**, a second insulating film **3** made of a silicon carbide film, a third insulating film **4** made of a carbon-containing silicon oxide film, a fourth insulating film **5** made of a silicon carbide film, a fifth insulating film **6** made of a carbon-containing silicon oxide film, and a sixth insulating film **13** made of a silicon carbide film are deposited in sequence over the first insulating film **1** and the lower-level metal interconnects **2**.

Then, a photoresist is applied onto the sixth insulating film **13** and a photolithography process is performed on the photoresist, thereby forming a resist film (not shown) having a hole pattern. Thereafter, with the resist film used as a mask, the sixth insulating film **13** and the fifth insulating film **6** are sequentially dry-etched, and then the photoresist is removed by ashing. By these steps, a hole **14**, which corresponds to a via hole **7** (see FIG. **8(e)**), is formed in the sixth insulating film **13** and the fifth insulating film **6,** as shown in FIG. **8(c).**

Subsequently, a photoresist is applied onto the sixth insulating film **13** and a photolithography process is performed on the photoresist, thereby forming a resist film **15** having a desired trench pattern. More specifically, the resist film **15**, having openings **15a** that correspond to a trench for wiring **8** (see FIG. **8(e)**), is formed.

Next, the sixth insulating film **13**, the fifth insulating film **6**, the fourth insulating film **5**, and the third insulating film **4** are dry-etched in sequence with the resist film **15** having the trench pattern and the sixth and fifth insulating films **13** and **6** having the hole pattern used as masks. By these steps, as shown in FIG. **8(e)**, the via hole **7** is formed in the third insulating film **4,** while the trench **8** is formed in the fourth and fifth insulating films **5** and **6**. It should be noted that after the dry-etching process, the resist film **15** is removed and a cleaning process is performed. Thereafter, part (i.e., the via hole **7** formation region) of the second insulating film **3**, part (i.e., the trench **8** formation region) of the fourth insulating film **5**, and the sixth insulating film **13**, each of which is made of a silicon carbide film, are removed at the same time by performing an etchback process on the entire surface of the substrate. By these steps, as shown in FIG. **8(e)**, the desired via hole **7** and the desired trench **8** are formed.

Next, a barrier metal film **9** and a copper film **10** are deposited in this order on the fifth insulating film **6** so that the via hole **7** and the trench 8 are filled completely. Thereafter, the barrier metal film **9** and the copper film **10** are removed by a CMP (chemical mechanical polishing) process where they are located externally of the trench **8.** By these steps, as shown in FIG. **8(f),** a via plug **11** is formed in the via hole **7,** while upper-level metal interconnects **12** are formed in the trench **8**.

In the non-patent related document 1, it is reported that resist poisoning caused by diffusion of an amine or the like through the hole **14** is suppressed by using the silicon carbide films that contain no nitrogen, as the second, fourth and sixth insulating films **3**, **5** and **13.**

Nevertheless, in the aforementioned conventional interconnection structure, the fact that the nitrogen-non-containing silicon carbide films, which are poorer in film quality than silicon carbon nitride films, are used instead of using silicon carbon nitride films for the purpose of preventing resist poisoning causes a problem in that the amount of leakage current is increased. In addition, the film stability of the silicon carbide films is poor, which produces another problem in that the film quality varies with passage of time if the films are left standing after deposited.

### DISCLOSURE OF INVENTION

In view of the above problems, it is therefore an object of the present invention to prevent occurrence of resist poisoning, while suppressing leakage current increase and film quality change with time in insulating films provided between interconnects.

In order to achieve the above object, a first inventive electronic device includes: a low dielectric constant film having a hole, a nitrogen-non-containing insulating film formed under the low dielectric constant film, and a nitrogen-containing insulating film formed under the nitrogen-non-containing insulating film.

In the first inventive electronic device, the nitrogen-non-containing insulating film is interposed between the low dielectric constant film, serving as an insulating film between interconnects, and the underlying nitrogen-containing insulating film. In other words, the low dielectric constant film and the nitrogen-containing insulating film are not in direct contact with each other, which suppresses the nitrogen from entering the low dielectric constant film. Therefore, when a chemically amplified resist is applied onto the low dielectric constant film with the hole formed therein, diffusion of an amine or the like from the low dielectric constant film through the hole into the resist, that is, a resist poisoning phenomenon, is prevented. In addition, since the nitrogen-containing insulating film (e.g., a silicon carbon nitride film) with excellent film quality is formed under the low dielectric constant film, it is possible to prevent leakage current increase or film quality change over time.

Furthermore, in the first inventive electronic device, if the nitrogen-non-containing insulating film is deposited by, e.g., a plasma CVD (chemical vapor deposition) process, the film quality of the underlying nitrogen-containing insulating film is stabilized, such that nitrogen contained in the nitrogen-containing insulating film is not likely to be liberated. It is thus possible to more reliably suppress the nitrogen from entering the low dielectric constant film.

It should be noted that the term "nitrogen-non-containing insulating film" as used herein means an insulating film in which nitrogen is contained at a concentration less than 1 × 10¹⁹ atoms/cm³.

In the first inventive electronic device, the hole preferably passes through the nitrogen-non-containing insulating film and the nitrogen-containing insulating film, the electronic device preferably further includes a lower-level interconnect which is located under the hole and connected with the hole, and the upper surface of the lower-level interconnect, except for a region in which the lower-level interconnect is connected with the hole, is preferably covered with the nitrogen-containing insulating film.

Then, oxidation of the lower-level interconnect is prevented by using an insulating film that contains no oxygen as the nitrogen-containing insulating film.

In the first inventive electronic device, the lower surface of the low dielectric constant film is preferably in contact with the upper surface of the nitrogen-non-containing insulating film.

Then, it is possible to more reliably suppress the nitrogen from entering the low dielectric constant film.

A second inventive electronic device includes: a low dielectric constant film having a hole, a nitrogen-non-containing insulating film formed over the low dielectric constant film, and a nitrogen-containing insulating film formed over the nitrogen-non-containing insulating film.

In the second inventive electronic device, the nitrogen-non-containing insulating film is interposed between the low dielectric constant film, serving as an insulating film between interconnects, and the nitrogen-containing insulating film provided over the low dielectric constant film. In other words, the low dielectric constant film and the nitrogen-containing insulating film are not in direct contact with each other, which suppresses the nitrogen from entering the low dielectric constant film. Therefore, when a chemically amplified resist is applied over the low dielectric constant film with the hole formed therein, diffusion of an amine or the like from the low dielectric constant film through the hole into the resist, that is, a resist poisoning phenomenon, is prevented. In addition, since the nitrogen-containing insulating film (e.g., a silicon carbon nitride film) with excellent film quality is formed over the low dielectric constant film, it is possible to prevent leakage current increase or film quality change over time.

Furthermore, in the second inventive electronic device, the nitrogen-containing insulating film is formed over the low dielectric constant film with the nitrogen-non-containing insulating film interposed therebetween, so that after the low dielectric constant film is formed, the low dielectric constant film is not directly exposed to an atmosphere (such as plasma) that contains nitrogen. It is therefore possible to more reliably suppress nitrogen from entering the low dielectric constant film.

In the second inventive electronic device, the nitrogen-containing insulating film is preferably an anti-reflection film, and a trench, which is connected with the hole, is preferably formed in the nitrogen-containing insulating film, the nitrogen-non-containing insulating film, and at least an upper portion of the low dielectric constant film.

This eliminates the need for forming a new anti-reflection film, made of, e.g., an organic material, in the lithography process for forming the hole or the trench, thereby allowing the number of process steps to be reduced.

In the second inventive electronic device, the upper surface of the low dielectric constant film is preferably in contact with the lower surface of the nitrogen-non-containing insulating film.

Then, it is possible to more reliably suppress the nitrogen from entering the low dielectric constant film.

A third inventive electronic device includes: a low dielectric constant film having a hole, a first nitrogen-non-containing insulating film formed under the low dielectric constant film, and a second nitrogen-non-containing insulating film formed over the low dielectric constant film, wherein the hole passes through the first nitrogen-non-containing insulating film, and a trench, which is connected with the hole, is formed in the second nitrogen-non-containing insulating film and at least an upper portion of the low dielectric constant film.

In the third inventive electronic device, the nitrogen-non-containing insulating films are formed over and under the low dielectric constant film serving as an insulating film between interconnects, which reliably suppresses nitrogen from entering the low dielectric constant film. Therefore, after the formation of the hole in the low dielectric constant film, when a chemically amplified resist is applied over the low dielectric constant film in the lithography process for forming the trench which is connected with the hole, diffusion of an amine or the like from the low dielectric constant film through the hole into the resist, that is, a resist poisoning phenomenon, is prevented.

In the third inventive electronic device, the lower surface of the low dielectric constant film is preferably in contact with the upper surface of the first nitrogen-non-containing insulating film.

Then, it is possible to more reliably suppress nitrogen from entering the low dielectric constant film.

In the third inventive electronic device, the upper surface of the low dielectric constant film is preferably in contact with the lower surface of the second nitrogen-non-containing insulating film.

Then, it is possible to more reliably suppress nitrogen from entering the low dielectric constant film.

A fourth inventive electronic device includes: a low dielectric constant film having a hole, and a low density insulating film having a film density of 1.3 g/cm³ or lower and formed over the low dielectric constant film.

In the fourth inventive electronic device, the low density insulating film is formed over the low dielectric constant film serving as an insulating film between interconnects. Thus, nitrogen taken into the low dielectric constant film and nitrogen present in the low density insulating film itself are externally released easily through the low density insulating film. This prevents an amine or the like from diffusing only into the hole formed in the low dielectric constant film. Accordingly, when a chemically amplified resist is applied over the low dielectric constant film, the amount of an amine or the like present per unit volume of the resist where the resist is located near the hole is reduced extremely, which results in the prevention of resist poisoning. It should be noted that in the fourth inventive electronic device, the density of the low density insulating film is preferably 0.4 g/cm³ or higher in consideration of the stability of the film.

In the fourth inventive electronic device, the low density insulating film preferably contains nitrogen.

Then, the low density insulating film has excellent film quality, thereby preventing leakage current increase or film quality change over time.

The fourth inventive electronic device preferably further includes a nitrogen-containing insulating film formed under the low dielectric constant film.

Then, the nitrogen-containing insulating film has excellent film quality, so that leakage current increase or film quality change over time is prevented.

In the first, second, third, and fourth inventive electronic devices, the low dielectric constant film is preferably a carbon-containing silicon oxide film or a porous film.

Then, capacitance between the interconnects is reduced reliably. As the carbon-containing silicon oxide film, a SiOC film may be used.

A first inventive method for fabricating an electronic device includes: the step of forming a nitrogen-non-containing insulating film and a low dielectric constant film in sequence over a nitrogen-containing insulating film; the step of forming a hole in the low dielectric constant film; the step of applying a chemically amplified resist on the low dielectric constant film with the hole formed therein, and subjecting the chemically amplified resist to exposure and development processes, thereby forming a resist film having an opening in a predetermined region that includes a region in which the hole is formed; and the step of etching the low dielectric constant film with the resist film used as a mask, thereby forming a trench which is connected with the hole.

In the first inventive electronic device fabrication method, after the hole is formed in the low dielectric constant film, which is formed over the nitrogen-containing insulating film with the nitrogen-non-containing insulating film interposed therebetween, the chemically amplified resist is applied on the low dielectric constant film. In other words, the nitrogen-non-containing insulating film is interposed between the low dielectric constant film and the nitrogen-containing insulating film, such that the low dielectric constant film and the nitrogen-containing insulating film are not in direct contact with each other. This suppresses the nitrogen from entering the low dielectric constant film. Therefore, when the chemically amplified resist is applied onto the low dielectric constant film with the hole formed therein, diffusion of an amine or the like through the hole into the resist, that is, a resist poisoning phenomenon, is prevented. In addition, since the nitrogen-containing insulating film (e.g., a silicon carbon nitride film) with excellent film quality is formed under the low dielectric constant film, it is possible to prevent leakage current increase or film quality change over time.

Furthermore, according to the first inventive method, if the nitrogen-non-containing insulating film is deposited by, e.g., a plasma CVD process, the film quality of the underlying nitrogen-containing insulating film is stabilized, such that the nitrogen contained in the nitrogen-containing insulating film is not likely to be liberated. As a result, it is possible to more reliably suppress the nitrogen from entering the low dielectric constant film.

In the first inventive method, the nitrogen-containing insulating film is preferably formed so as to cover a lower-level interconnect.

Then, oxidation of the lower-level interconnect is prevented by using an insulating film that contains no oxygen as the nitrogen-containing insulating film.

In the first inventive method, the hole-forming step preferably includes the step of forming the hole in the low dielectric constant film and the nitrogen-non-containing insulating film, and the method preferably further includes, after the trench-forming step, the step of removing part of the nitrogen-containing insulating film which is located under the hole.

Then, it is possible to prevent etching damage and ashing damage to the interconnects, devices and the like formed under the hole. Examples of the etching and ashing damage include, e.g., oxidation of the surfaces of the interconnects, devices and the like.

A second inventive method for fabricating an electronic device includes: the step of forming a nitrogen-non-containing insulating film and a nitrogen-containing insulating film in sequence over a low dielectric constant film; the step of forming a hole in the low dielectric constant film with the nitrogen-non-containing insulating film and the nitrogen-containing insulating film formed thereon; the step of applying a chemically amplified resist over the low dielectric constant film with the hole formed therein, and subjecting the chemically amplified resist to exposure and development processes, thereby forming a resist film having an opening in a predetermined region that includes a region in which the hole is formed; and the step of etching the low dielectric constant film with the resist film used as a mask, thereby forming a trench which is connected with the hole.

According to the second inventive method, after the nitrogen-non-containing insulating film and the nitrogen-containing insulating film are formed in this order over the low dielectric constant film, the hole is formed in the low dielectric constant film. Thereafter, the chemically amplified resist is applied over the low dielectric constant film. In other words, the nitrogen-non-containing insulating film is interposed between the low dielectric constant film and the nitrogen-containing insulating film, so that the low dielectric constant film and the nitrogen-containing insulating film are not in direct contact with each other. This suppresses the nitrogen from entering the low dielectric constant film. Therefore, when the chemically amplified resist is applied over the low dielectric constant film with the hole formed therein, diffusion of an amine or the like through the hole into the resist, that is, a resist poisoning phenomenon, is prevented. In addition, since the nitrogen-containing insulating film (e.g., a silicon carbon nitride film) with excellent film quality is formed over the low dielectric constant film, it is possible to prevent leakage current increase or film quality change over time.

Furthermore, according to the second inventive method, since the nitrogen-containing insulating film is formed over the low dielectric constant film with the nitrogen-non-containing insulating film interposed therebetween, the low dielectric constant film is not directly exposed to an atmosphere (such as plasma) that contains nitrogen, after the low dielectric constant film is formed. It is thus possible to more reliably suppress nitrogen from entering the low dielectric constant film.

In the second inventive method, the nitrogen-containing insulating film preferably functions as an anti-reflection film in the resist-film forming step.

This eliminates the need for forming a new anti-reflection film, made of, e.g., an organic material, in the lithography process for forming the trench, thereby allowing the number of process steps to be reduced.

A third inventive method for fabricating an electronic device includes: the step of forming a low dielectric constant film and a second nitrogen-non-containing insulating film in sequence over a first nitrogen-non-containing insulating film; the step of forming a hole in the low dielectric constant film with the second nitrogen-non-containing insulating film formed thereon; the step of applying a chemically amplified resist over the low dielectric constant film with the hole formed therein, and subjecting the chemically amplified resist to exposure and development processes, thereby forming a resist film having an opening in a predetermined region that includes a region in which the hole is formed; and the step of etching the low dielectric constant film with the resist film used as a mask, thereby forming a trench which is connected with the hole.

According to the third inventive method, after the hole is formed in the low dielectric constant film with the nitrogen-non-containing insulating films formed thereon and thereunder, the chemically amplified resist is applied over the low dielectric constant film. It is therefore possible to reliably suppress nitrogen from entering the low dielectric constant film. Thus, when the chemically amplified resist is applied over the low dielectric constant film with the hole formed therein, diffusion of an amine or the like through the hole into the resist, that is, a resist poisoning phenomenon, is prevented.

In the first, second, and third inventive methods, the nitrogen-non-containing insulating films are preferably deposited by a CVD process.

Then, if silicon oxide films are formed as the nitrogen-non-containing insulating films by a plasma CVD process in which TEOS, for example, is used, the density (which is about 2.3 g/cm³) of the silicon oxide films is greater than the density of the low dielectric constant film, which is a carbon-containing silicon oxide film, for example. Thus, the nitrogen-non-containing insulating films formed out of the silicon oxide films function as barrier layers against nitrogen. It is therefore possible to more reliably suppress nitrogen from entering the low dielectric constant film.

The first, second, and third inventive methods preferably further include, between the hole-forming step and the resist-film forming step, the step of forming a dummy plug in the hole.

Then, the dummy plug, made of, e.g., an organic material, covers the wall surface of the hole which includes the interface(s) between the low dielectric constant film and the nitrogen-non-containing insulating film(s). More specifically, since the interface(s) and a damage layer in the wall surface of the hole are covered by the dummy plug, nitrogen diffusion from the interface(s) or the damage layer into the hole is suppressed, thereby reliably avoiding resist poisoning.

A fourth inventive method for fabricating an electronic device includes: the step of forming a low density insulating film whose film density is 1.3 g/cm³ or lower on a low dielectric constant film; the step of forming a hole in the low dielectric constant film with the low density insulating film formed thereon; the step of applying a chemically amplified resist over the low dielectric constant film with the hole formed therein, and subjecting the chemically amplified resist to exposure and development processes, thereby forming a resist film having an opening in a predetermined region that includes a region in which the hole is formed; and the step of etching the low dielectric constant film with the resist film used as a mask, thereby forming a trench which is connected with the hole.

According to the fourth inventive method, after the low density insulating film is formed on the low dielectric constant film, the hole is formed in the low dielectric constant film. Thereafter, the chemically amplified resist is applied over the low dielectric constant film. Thus, nitrogen taken into the low dielectric constant film and nitrogen present in the low density insulating film itself are externally released easily through the low density insulating film. This prevents an amine or the like from diffusing only into the hole formed in the low dielectric constant film. Accordingly, when the chemically amplified resist is applied over the low dielectric constant film, the amount of an amine or the like present per unit volume of the resist where the resist is located near the hole is reduced extremely, which results in the prevention of resist poisoning. It should be noted that, in the fourth inventive method, the density of the low density insulating film is preferably 0.4 g/cm³ or higher in consideration of the stability of the film.

The fourth inventive method preferably further includes, after the low-density-insulating-film forming step, the step of subjecting the low density insulating film to a heat treatment or applying an energy wave to the low density insulating film.

Then, the film quality of the low density insulating film is stabilized, while a greater amount of nitrogen is released externally from the low dielectric constant film and the low density insulating film through the low density insulating film. In this method, if the energy wave is an electron beam or ultraviolet radiation, the above-mentioned effect is achieved reliably.

In the first, second, third, and fourth inventive methods, the low dielectric constant film is preferably a carbon-containing silicon oxide film or a porous film.

Then, capacitance between the interconnects is lowered reliably. As the carbon-containing silicon oxide film, a SiOC film may be used.

### BRIEF DESCRIPTION OF THE DRAWINGS

FIG. **1** is a cross sectional view illustrating an interconnection structure in an electronic device in accordance with a first embodiment of the present invention.
FIGS. **2(a)** through **2(f)** are cross sectional views indicating process steps of a method for fabricating the electronic device of the first embodiment of the present invention.
FIG. **3** is a cross sectional view illustrating an interconnection structure in an electronic device in accordance with a comparative example.
FIGS. **4(a)** through **4(f)** are cross sectional views indicating process steps of a method for fabricating the electronic device according to the comparative example.
FIG. **5** is a cross sectional view illustrating an interconnection structure in an electronic device in accordance with a second embodiment of the present invention.
FIGS. **6(a)** through **6(f)** are cross sectional views indicating process steps of a method for fabricating the electronic device according to the second embodiment of the present invention.
FIG. **7** is a cross sectional view illustrating an interconnection structure in a conventional electronic device.
FIGS. **8(a)** through **8(f)** are cross sectional views indicating process steps of a method for fabricating the conventional electronic device.

### DETAILED DESCRIPTION

### First embodiment

Hereinafter, an electronic device and a method for fabricating the device in accordance with a first embodiment of the present invention will be described with reference to the accompanying drawings.

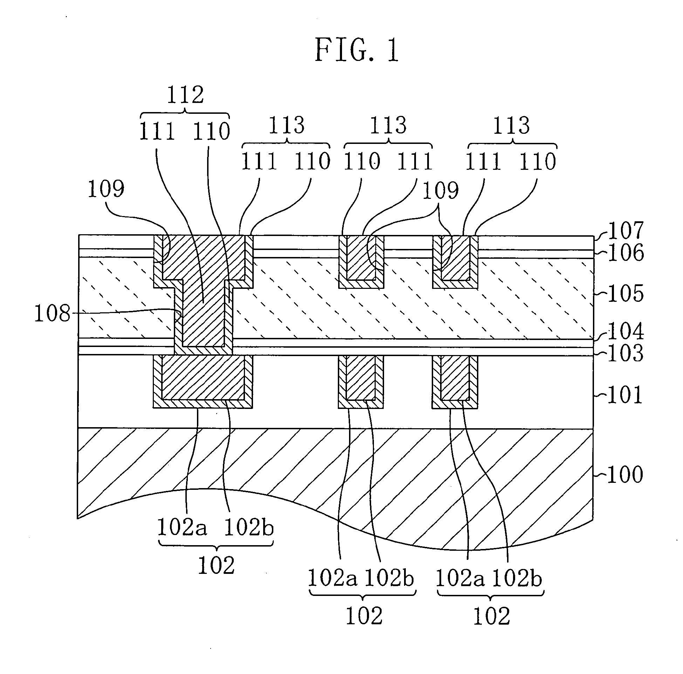

FIG. **1** is a cross sectional view illustrating an interconnection structure in the electronic device in accordance with the first embodiment.

As shown in FIG. **1**, lower-level metal interconnects **102** are formed in a lower-level insulating film **101** formed on a substrate **100** made of, e.g., silicon. Each lower-level metal interconnect **102** is formed of, e.g., a tantalum-nitride/tantalum multilayer film **102a** and a copper film **102b**. On the lower-level metal interconnects **102** and the lower-level insulating film **101,** a first nitrogen-containing insulating film **103** made of, e.g., a silicon carbon nitride film is formed. On the first nitrogen-containing insulating film **103**, a first nitrogen-non-containing insulating film **104** made of, e.g., a silicon oxide film is formed. On the first nitrogen-non-containing insulating film **104**, a low dielectric constant film 105 made of, e.g., a carbon-containing silicon oxide film is formed. On the low dielectric constant film **105**, a second nitrogen-non-containing insulating film **106** made of, e.g., a silicon oxide film is formed. On the second nitrogen-non-containing insulating film **106**, a second nitrogen-containing insulating film **107** made of, e.g., a silicon oxynitride film is formed. In the first nitrogen-containing insulating film **103**, the first nitrogen-non-containing insulating film **104** and (the lower portion of) the low dielectric constant film **105**, a via hole **108**, which reaches at least one of the lower-level metal interconnects **102**, is formed. In (the upper portion of) the low dielectric constant film **105**, the second nitrogen-non-containing insulating film **106**, and the second nitrogen-containing insulating film **107**, a trench for wiring **109**, which is connected with the via hole **108**, is formed. In the via hole **108** and the trench **109**, a tantalum-nitride/tantalum multilayer film **110** and a copper film **111** are formed in sequence to form a via plug **112** and upper-level metal interconnects **113**. The via plug **112** connects the lower-level metal interconnects **102** with the upper-level metal interconnects **113**.

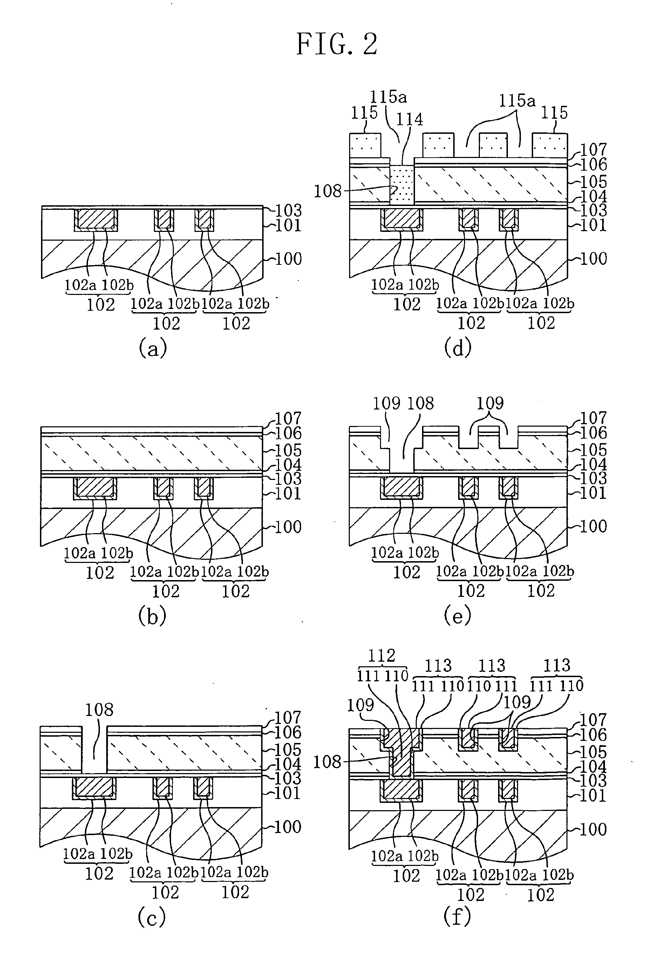

FIGS. **2(a)** through **2(f)** are cross sectional views indicating process steps of a method for fabricating the electronic device of the first embodiment, that is, a method for fabricating the electronic device shown in FIG. **1**.

First, as shown in FIG. **2(a)**, a lower-level insulating film **101** made of, e.g., a silicon oxide film is formed on a substrate **100** made of, e.g., silicon, after which lower-level metal interconnects **102**, formed of, e.g., a tantalum-nitride/tantalum multilayer film **102a** and a copper film **102b**, are buried in the lower-level insulating film **101**. More specifically, after the formation of the lower-level insulating film **101**, a resist film (not shown) having a trench pattern for the lower-level metal interconnects is formed on the lower-level insulating film **101** by a photolithography process, and the lower-level insulating film **101** is then dry-etched with the resist film used as a mask, thereby forming a trench for wiring. Thereafter, the tantalum-nitride/tantalum multilayer film **102a** and the copper film **102b** are deposited in this order on the lower-level insulating film **101** so that the trench is filled completely. The multilayer film **102a** and the copper film **102b** are then removed by a CMP process where they are located externally of the trench, thereby forming the lower-level metal interconnects **102**.

Next, as shown in FIG. **2(a)**, a first nitrogen-containing insulating film **103** made of, e.g., a silicon carbon nitride film is deposited to a thickness of 50 nm on the lower-level insulating film **101** and the lower-level metal interconnects **102**.

Subsequently, as shown in FIG. **2(b)**, a first nitrogen-non-containing insulating film **104** made of, e.g., a silicon oxide film is deposited to a thickness of 50 nm on the first nitrogen-containing insulating film **103**. In this step, the silicon oxide film, serving as the first nitrogen-non-containing insulating film **104**, is deposited by a plasma CVD process in which TEOS, for example, is used. Thereafter, a low dielectric constant film **105** made of, e.g., a carbon-containing silicon oxide film is deposited to a thickness of 450 nm on the first nitrogen-non-containing insulating film **104**. On the low dielectric constant film **105**, a second nitrogen-non-containing insulating film **106** made of, e.g., a silicon oxide film is then deposited to a thickness of 30 nm. In this step, the silicon oxide film, serving as the second nitrogen-non-containing insulating film **106**, is deposited by a plasma CVD process in which TEOS, for example, is used. Thereafter, a second nitrogen-containing insulating film **107** made of, e.g., a silicon oxynitride film is deposited to a thickness of 50 nm on the second nitrogen-non-containing insulating film **106**. The silicon oxynitride film, serving as the second nitrogen-containing insulating film **107**, will act as an anti-reflection film in a later photolithography process. The thickness of the silicon oxynitride film serving as the anti-reflection film is preferably from 60 nm to 100 nm in the case of a design rule greater than 0.18 µm, and preferably from 30 nm to 70 nm in the case of a 0.18 µm or smaller design rule. In a case where the second nitrogen-containing insulating film 107 is formed out of a film made of a material other than silicon oxynitride, it is preferable that the thickness of the second nitrogen-containing insulating film **107** be set in such a manner that the value obtained by dividing the optical thickness of the second nitrogen-containing insulating film **107** by the real part of the refractive index of a silicon oxynitride film is within the above-mentioned value ranges, wherein the optical thickness of the second nitrogen-containing insulating film **107** = [the real part of the refractive index of the second nitrogen-containing insulating film **107**] × [the thickness (i.e., the physical thickness) of the second nitrogen-containing insulating film **107**.]

Subsequently, a photoresist is applied onto the second nitrogen-containing insulating film **107** and a photolithography process is performed on the photoresist, thereby forming a resist film (not shown) having a hole pattern. Thereafter, with the resist film used as a mask, the second nitrogen-containing insulating film **107**, the second nitrogen-non-containing insulating film **106**, the low dielectric constant film **105** and the first nitrogen-non-containing insulating film **104** are dry-etched in sequence, and the photoresist is then removed by ashing. By these steps, a via hole **108** is formed, as shown in FIG. **2(a).**

Next, as shown in FIG. **2(d)**, a dummy plug **114**, made of, e.g., an organic material, is formed in the via hole 108. In this embodiment, the dummy plug **114** is formed in such a manner that the upper surface of the dummy plug **114** is higher than the interface between the low dielectric constant film **105** and the second nitrogen-non-containing insulating film **106**. It should be noted that the formation of the dummy plug **114** is not indispensable in this embodiment. Thereafter, a photoresist is applied onto the second nitrogen-containing insulating film **107** and then a photolithography (exposure and development) process is performed on the photoresist, thereby forming a resist film 115 having a desired trench pattern. More specifically, the resist film **115** having openings **115a** that correspond to a trench for wiring **109** (see FIG. **2(e)**) is formed. The regions in which the openings **115a** are formed include the region in which the via hole **108** is formed.

Next, the second nitrogen-containing insulating film **107**, the second nitrogen-non-containing insulating film **106** and (the upper portion of) the low dielectric constant film **105** are sequentially dry-etched with the dummy plug **114** and the resist film **115** having the trench pattern used as masks. By this step, the trench **109**, which is connected with the via hole **108**, is formed, as shown in FIG. **2(e)**. It should be noted that after the dry-etching process, the dummy plug **114** and the resist film **115** are removed and a cleaning process is then performed.

Subsequently, part of the first nitrogen-containing insulating film **103** formed of the silicon carbon nitride film, which is located under the via hole **108**, is removed by performing an etchback process on the entire surface of the substrate. A tantalum-nitride/tantalum multilayer film **110** and a copper film **111** are then deposited in sequence on the second nitrogen-containing insulating film **107** so that the via hole **108** and the trench **109** are filled completely. The multilayer film **110** and the copper film **111** are then removed by a CMP process where they are located externally of the trench **109**. By these steps, as shown in FIG. **2(f),** a via plug **112** is formed in the via hole **108,** while upper-level metal interconnects **113** are formed in the trench **109**. It should be noted that since the second nitrogen-containing insulating film **107** and the second nitrogen-non-containing insulating film **106** do not necessarily have to be left finally, these films may be completely or partially removed by the above-mentioned etchback process or CMP process.

As described above, in the first embodiment, the first nitrogen-non-containing insulating film **104** is interposed between the low dielectric constant film (i.e., the carbon-containing silicon oxide film) **105** and the first nitrogen-containing insulating film (i.e., the silicon carbon nitride film) **103** located under the low dielectric constant film **105**. Therefore, resist poisoning is suppressed for the following three reasons, despite the fact that the first nitrogen-containing insulating film **103** is used.
(1) Since the first nitrogen-containing insulating film **103** and the low dielectric constant film **105** are not in direct contact with each other, it is possible to suppress the nitrogen from entering the low dielectric constant film **105**. Therefore, diffusion of an amine or the like through the via hole **108** into the resist, that is, a resist poisoning phenomenon, is prevented in the lithography process for forming the trench **109**.
(2) As the first nitrogen-non-containing insulating film **104**, the silicon oxide film is formed by a plasma CVD process in which TEOS, for example, is used. Thus, the density (which is about 2.3 g/cm³) of the silicon oxide film is greater than the density of the low dielectric constant film **105**, that is, the carbon-containing silicon oxide film. The first nitrogen-non-containing insulating film **104** formed out of the silicon oxide film therefore functions as a barrier layer against the nitrogen, which suppresses the nitrogen from entering the low dielectric constant film **105** more reliably.
(3) Since the first nitrogen-non-containing insulating film **104** is deposited by a plasma CVD process, the film quality of the underlying first nitrogen-containing insulating film **103**, that is, the silicon carbon nitride film, is stabilized. Consequently, the nitrogen contained in the first nitrogen-containing insulating film **103** is not likely to be liberated. More specifically, since the silicon carbon nitride film is exposed to the oxygen-containing plasma, the surface portion of the silicon carbon nitride film undergoes oxidation to have a higher film density. As a result, the surface portion functions as a barrier against diffusion of the nitrogen contained in the silicon carbon nitride film. It is therefore possible to more reliably suppress the nitrogen from entering the low dielectric constant film **105**.

In the first embodiment, the effects mentioned above allow resist poisoning to be suppressed, while permitting the formation of the first nitrogen-containing insulating film **103** (e.g., a silicon carbon nitride film) with excellent film quality under the low dielectric constant film **105**. Accordingly, it is possible to prevent leakage current increase or film quality changes with time. Moreover, since the silicon carbon nitride film, serving as the first nitrogen-containing insulating film **103**, does not contain oxygen, the copper films **102b** are not oxidized when the first nitrogen-containing insulating film **103** is deposited on the copper films **102b** that form the lower-level metal interconnects **102**.

In addition, in the first embodiment, the second nitrogen-non-containing insulating film **106** is interposed between the low dielectric constant film (i.e., the carbon-containing silicon oxide film) **105** and the second nitrogen-containing insulating film (i.e., the silicon oxynitride film) **107** provided over the low dielectric constant film **105**. Thus, resist poisoning is suppressed for the following three reasons, despite the fact that the second nitrogen-containing insulating film **107** is used.
(1) Since the second nitrogen-containing insulating film **107** and the low dielectric constant film **105** are not in direct contact with each other, it is possible to suppress the nitrogen from entering the low dielectric constant film **105**. Therefore, diffusion of an amine or the like through the via hole **108** into the resist, that is, a resist poisoning phenomenon, is prevented in the lithography process for forming the trench **109**.
(2) As the second nitrogen-non-containing insulating film **106**, the silicon oxide film is formed by a plasma CVD process in which TEOS, for example, is used. Thus, the density (which is about 2.3 g/cm³) of the silicon oxide film is greater than the density of the low dielectric constant film **105**, that is, the carbon-containing silicon oxide film. Thus, the second nitrogen-non-containing insulating film **106** formed out of the silicon oxide film functions as a barrier layer against the nitrogen, which suppresses the nitrogen from entering the low dielectric constant film **105** more reliably.
(3) Since the second nitrogen-containing insulating film **107** is provided over the low dielectric constant film **105** with the second nitrogen-non-containing insulating film **106** interposed therebetween, the low dielectric constant film **105** is not directly exposed to an nitrogen-containing atmosphere (e.g., plasma) after the low dielectric constant film **105** is formed. It is thus possible to suppress nitrogen from entering the low dielectric constant film **105** more reliably.

In the first embodiment, the effects mentioned above allow resist poisoning to be suppressed, while permitting the formation of the second nitrogen-containing insulating film **107** (e.g., a silicon carbon nitride film) with excellent film quality over the low dielectric constant film **105**. Accordingly, it is possible to prevent leakage current increase or film quality changes with time. Moreover, the silicon oxynitride film having the reflection-preventing effect is used as the second nitrogen-containing insulating film **107**. This eliminates the need for forming a new anti-reflection film, made of, e.g., an organic material, in the lithography processes for forming the via hole **108** and the trench **109**, thereby allowing the number of process steps to be reduced. It also becomes easy to ensure the selective ratio of the second nitrogen-containing insulating film **107** with respect to the resist, which makes it easier to etch the second nitrogen-containing insulating film **107**. Furthermore, as described above, no anti-reflection film has to be applied when the trench 109 is formed, such that the upper surface of the dummy plug **114** can be set to the same height as the bottom face of the trench **109** to be formed. This prevents a fence-like residue to remain on the bottom face of the trench **109** in the vicinity of the via hole **108**, when the etching process for forming the trench **109** is performed.

Also, in the first embodiment, the first nitrogen-containing insulating film **103** is left under the via hole **108**, that is, on the lower-level metal interconnects **102**, until the formation of the trench **109** is completed. This reduces damage (e.g., oxidation of the surfaces of the lower-level metal interconnects **102**) to the lower-level metal interconnects **102**, caused by the etching and ashing processes.

Moreover, in the first embodiment, the dummy plug **114** is formed in the via hole 108 prior to the photolithography process for forming the trench **109**. Therefore, the dummy plug **114** covers the wall surface of the via hole **108**, which includes the interfaces between the low dielectric constant film **105** and the first and second nitrogen-non-containing insulating films **104** and **106**. More specifically, since those interfaces and a damage layer in the wall surface of the via hole **108** are covered by the dummy plug **114**, nitrogen diffusion from the interfaces or the damage layer into the via hole **108** is prevented, thereby reliably avoiding resist poisoning. In addition, the presence of the dummy plug **114** in the via hole **108** allows the surface of the resist applied to be planarized, so that the accuracy of the pattern obtained by the photolithography process is increased.

In the first embodiment, a silicon oxynitride film having the effect of preventing reflection is used as the second nitrogen-containing insulating film **107**. However, instead of this, another kind of insulating film that contains nitrogen (more accurately, a film containing nitrogen at a concentration of 1 × 10¹⁹ atoms/cm³ or higher) may be used. For example, if a silicon nitride film is used as the second nitrogen-containing insulating film **107**, the second nitrogen-containing insulating film **107** can be used as a hard mask in the etching process for forming the via hole **108** or the trench **109**. This is effective in cases where a porous film or a film (i.e., an insulating film having a further lower dielectric constant) that contains a higher concentration of carbon is used as the low dielectric constant film **105**. Alternatively, a silicon carbon nitride (SiCN) film may be used as the second nitrogen-containing insulating film **107**.

In the first embodiment, a silicon carbon nitride film is used as the first nitrogen-containing insulating film **103**. However, instead of this, another kind of insulating film that contains nitrogen, e.g., a silicon nitride film (a SiN film) may be used.

In the first embodiment, silicon oxide films are used as the first and second nitrogen-non-containing insulating films **104** and **106**. Instead of the silicon oxide films, other kinds of insulating films that contain no nitrogen (more accurately, films that contain nitrogen at a concentration less than 1 × 10¹⁹ atoms/cm³), e.g., oxygen-added silicon carbide films (SiCO films) or silicon carbide films (SiC films) may be used.

Moreover, in the first embodiment, as the carbon-containing silicon oxide film serving as the low dielectric constant film **105**, a SiOC film, e.g., may be used.

In the first embodiment, (the lower surface of) the low dielectric constant film **105** is in direct contact with (the upper surface of) the first nitrogen-non-containing insulating film **104**. However, another nitrogen-non-containing insulating film may be provided between the low dielectric constant film **105** and the first nitrogen-non-containing insulating film **104**. Likewise, although (the upper surface of) the low dielectric constant film **105** is in direct contact with (the lower surface of) of the second nitrogen-non-containing insulating film **106**, another nitrogen-non-containing insulating film may be provided between the low dielectric constant film 105 and the second nitrogen-non-containing insulating film **106**.

Also, although in the first embodiment, the present invention is applied to form the interconnection structure including the lower-level metal interconnects **102** and the upper-level metal interconnects **113** that are connected with each other by the via plug **112**, the present invention is not limited to this. It will be obvious that the present invention is applicable to, for example, formation of a memory cell structure including a transistor (i.e., doped layers thereof) and a capacitor (i.e., a lower electrode thereof) that are connected with each other by a contact plug.

### (Comparative example)

Hereinafter, as a comparative example of the first embodiment, an electronic device having a line-to-line insulating-film structure, in which a low dielectric constant film and a nitrogen-containing insulating film are in direct contact with each other, will be described, and a method for fabricating the device will be also discussed (See pp. 15-17 in "Proceedings of the 2002 International Interconnect Technology Conference" by Kazuyuki Higashi et al.)

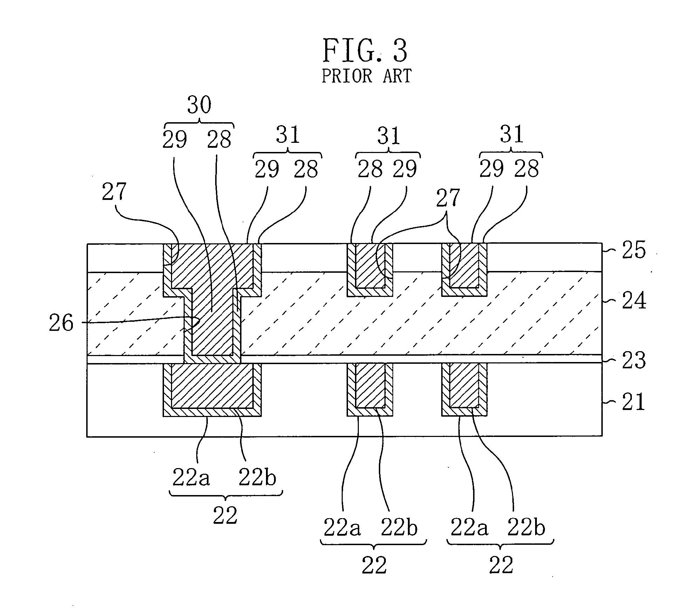

FIG. **3** is a cross sectional view illustrating the interconnection structure in the electronic device in accordance with the comparative example.

As shown in **FIG. 3,** lower-level metal interconnects **22,** made of a tantalum-nitride/tantalum multilayer film **22a** and a copper film **22b,** are formed in a first insulating film **21** formed on a silicon substrate (not shown). On the lower-level metal interconnects **22** and the first insulating film **21**, a second insulating film (a nitrogen-containing insulating film) **23** made of a silicon carbon nitride film is formed. On the second insulating film **23**, a third insulating film (a low dielectric constant film) **24** made of a carbon-containing silicon oxide film is formed. On the third insulating film **24**, a fourth insulating film **25** made of a silicon oxide film is formed. The fourth insulating film **25** is formed using plasma which is free of contamination with nitrogen. In the second insulating film **23** and (at least the lower portion of) the third insulating film **24,** a via hole **26**, which reaches at least one of the lower-level metal interconnects **22**, is formed. In (the upper portion of) the third insulating film **24** and the fourth insulating film **25**, a trench for wiring **27**, which is connected with the via hole **26**, is formed. In the via hole **26** and the trench **27**, a tantalum-nitride/tantalum multilayer film **28** and a copper film **29** are formed in sequence to form a via plug **30** and upper-level metal interconnects **31**. The via plug **30** connects the lower-level metal interconnects **22** with the upper-level metal interconnects **31.**

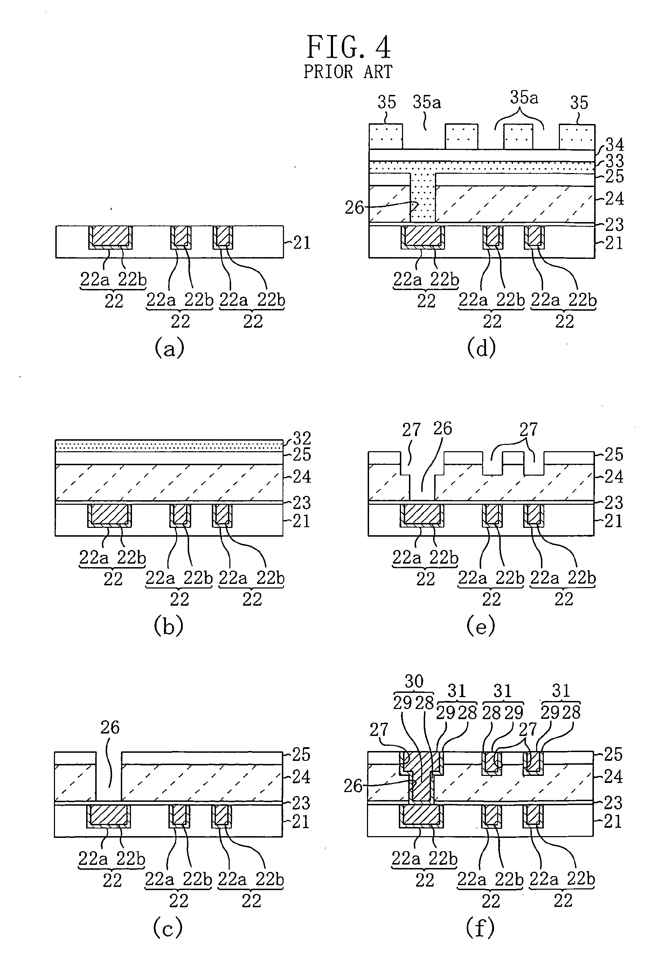

**FIGS. 4(a)** through **4(f)** are cross sectional views indicating process steps of a method for fabricating the electronic device according to the comparative example, that is, a method for fabricating the electronic device shown in FIG. **3**.

First, as shown in FIG. **4(a)**, a first insulating film **21** is formed on a silicon substrate (not shown), after which lower-level metal interconnects **22,** made of a tantalum-nitride/tantalum multilayer film **22a** and a copper film **22b,** are buried in the first insulating film **21**.

Next, as shown in FIG. **4(b)**, a second insulating film **23** made of a silicon carbon nitride film is deposited on the first insulating film **21** and the lower-level metal interconnects **22**. Thereafter, the second insulating film **23** is subjected to a plasma treatment so that the film quality of the second insulating film **23** is stabilized. Subsequently, a third insulating film **24** made of a carbon-containing silicon oxide film is deposited on the second insulating film **23**. Then, on the third insulating film **24**, a fourth insulating film **25** made of a silicon oxide film is deposited by a plasma CVD process, after which an organic anti-reflection film **32** is formed on the fourth insulating film **25**. It should be noted that the fourth insulating film **25** is formed using nitrogen-contamination-free plasma, after the underlying third insulating film **24** is subjected to a pretreatment which is free of nitrogen contamination.

Next, a photoresist is applied onto the organic anti-reflection film 32 and a photolithography process is performed on the photoresist, thereby forming a resist film (not shown) having a hole pattern. Thereafter, with the resist film used as a mask, the organic anti-reflection film 32, the fourth insulating film 25 and the third insulating film 24 are sequentially dry-etched, and the photoresist and the organic anti-reflection film 32 are then removed by ashing. By these steps, a via hole **26** is formed, as shown in FIG. **4(c).**

Next, as shown in FIG. 4(d), a lower-level resist film 33 is deposited on the fourth insulating film 25 so that the via hole 26 is filled completely, after which a SOG (spin on glass) film 34 is formed on the lower-level resist film 33. Thereafter, a photoresist is applied onto the SOG film 34 and a photolithography process is performed on the photoresist, thereby forming an upper-level resist film 35 having a desired trench pattern. More specifically, the upper-level resist film 35 having openings 35a that correspond to a trench for wiring 27 (see FIG. 4(e)) is formed.

Next, the SOG film 34 is dry-etched with the upper-level resist film 35 having the trench pattern used as a mask. Subsequently, with the patterned SOG film 34 (having the trench pattern) used as a mask, the lower-level resist film 33, the fourth insulating film 25, and (the upper portion of) the third insulating film 24 are dry-etched in this order. By these steps, as shown in FIG. 4(e), the trench 27, which is connected with the via hole 26, is formed. It should be noted that after the dry-etching process, the upper-level resist film 35, the SOG film 34, and the lower-level resist film 33 are removed and a cleaning process is performed.

Next, part of the second insulating film 23 which is located under the via hole 26 is removed by performing an etchback process on the entire surface of the substrate. Thereafter, a tantalum-nitride/tantalum multilayer film 28 and a copper film 29 are deposited in this order on the fourth insulating film 25 so that via hole 26 and the trench 27 are filled completely. The multilayer film **28** and the copper film **29** are then removed by a CMP process where they are located externally of the trench **29**. By these steps, as shown in FIG. **4(f),** a via plug **30** is formed in the via hole **26,** while upper-level metal interconnects **31** are formed in the trench **27**.

As described above, in the comparative example, the second insulating film **23**, that is, the silicon carbon nitride film, is plasma-treated for stabilization of the film quality, thereby suppressing resist poisoning.

Nevertheless, in the comparative example, nitrogen diffuses from the silicon carbon nitride film (i.e., the second insulating film **23**) into the third insulating film (i.e., the low dielectric constant film) **24** that is in direct contact with the silicon carbon nitride film, due to unstable nitrogen remaining within the silicon carbon nitride film or variations in the plasma treatment. As a result, diffusion of an amine or the like by way of the via hole **26** into the resist, that is, a resist poisoning phenomenon, cannot be suppressed sufficiently in the lithography process for forming the trench **27**.

Also, in the comparative example, after the pretreatment free of nitrogen contamination is performed, the fourth insulating film **25**, that is, the silicon oxide film, is formed on the third insulating film (i.e., the low dielectric constant film) **24** by using nitrogen-contamination-free plasma, whereby resist poisoning is suppressed. However, the silicon oxide film has no reflection-preventing effect, such that the organic anti-reflection film **32** has to be provided when the pattern for forming the via hole **26** is formed by lithography. Nevertheless, since the coating film thickness of the organic anti-reflection film **32** is large and it is difficult to secure the selective ratio of the organic anti-reflection film **32** with respect to the photoresist, the etching process for forming the via hole **26** becomes difficult. In addition, as described above, the lower-level resist film **33**, the SOG film **34** and the upper-level resist film **35** are used in combination, when the pattern for forming the trench **27** is formed by lithography. This makes it difficult to perform the etching process for forming the trench **27**. In this case, if a dimensional deviation or a misalignment occurs in the lithography process, regeneration of the pattern becomes difficult due to the use of the SOG film **34**. More specifically, unlike a resist film, the SOG film **34** cannot be removed easily by ashing or the like. In a case where an organic anti-reflection film is formed instead of the combination of the lower-level resist film **33**, the SOG film **34** and the upper-level resist film **35**, a problem similar to that occurring in the etching process for forming the via hole **26** arises.

In cases where a low dielectric constant film having a still lower dielectric constant (specifically, a film whose relative dielectric constant **ε** is lower than 2.8) is used, a process, in which a nitrogen-containing insulating film such as a silicon nitride film is formed on the low dielectric constant film and then used as a hard mask in an etching process, is effective in terms of achieving a low selective ratio with respect to the photoresist, as well as preventing ashing damage. In the comparative example, however, no structure or process other than that in which a silicon oxide film is formed on a low dielectric constant film without using nitrogen-containing plasma is allowed. In other words, no nitrogen-containing insulating films can be formed on the low dielectric constant film. Thus, considering that the dielectric constant of insulating films will be lowered in the future, the comparative example is disadvantageous. Moreover, in the comparative example, the relative dielectric constant of the above-mentioned silicon oxide film is as high as about 4.2, which causes the problem of increasing capacitance between the interconnects. Therefore, the comparative example is also unfavorable in terms of lowering of dielectric constant required in insulating films in the future.

In contrast, in the first embodiment, the structure (see FIG. 1), in which the first nitrogen-non-containing insulating film **104** is interposed between the low dielectric constant film **105** and the first nitrogen-containing insulating film **103** located under the low dielectric constant film **105**, and the second nitrogen-non-containing insulating film **106** is interposed between the low dielectric constant film **105** and the second nitrogen-containing insulating film **107** provided over the low dielectric constant film **105**, achieves the outstanding effect of solving all of the above-mentioned problems occurring in the comparative example.

### (Second embodiment)

Hereinafter, an electronic device and a method for fabricating the device in accordance with a second embodiment of the present invention will be described with reference to the accompanying drawings.

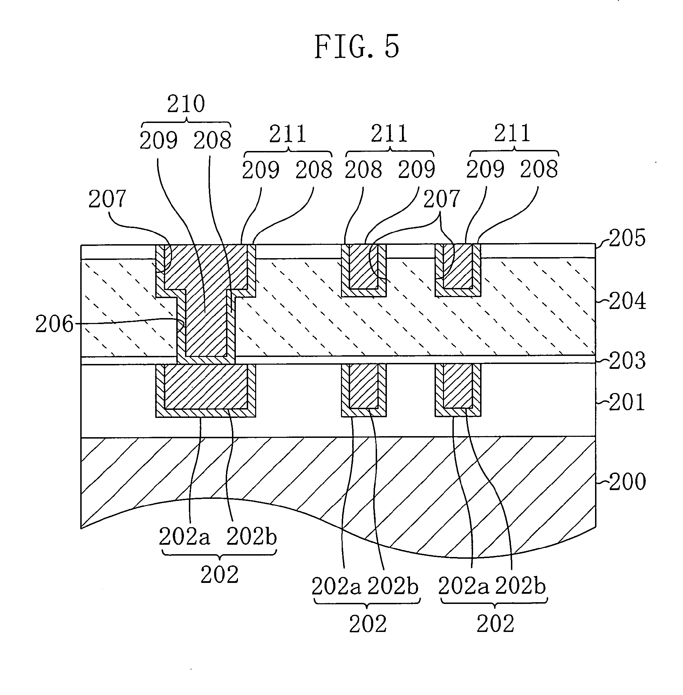

FIG. 5 is a cross sectional view illustrating an interconnection structure in the electronic device in accordance with the second embodiment.

As shown in FIG. **5**, lower-level metal interconnects **202**, made of, e.g., a tantalum-nitride/tantalum multilayer film **202a** and a copper film **202b**, are formed in a lower-level insulating film **201** formed on a substrate **200** made of, e.g., silicon. On the lower-level metal interconnects **202** and the lower-level insulating film **201**, a nitrogen-containing insulating film **203** made of, e.g., a silicon carbon nitride film is formed. On the nitrogen-containing insulating film **203**, a low dielectric constant film **204** made of, e.g., a carbon-containing silicon oxide film is formed. On the low dielectric constant film **204**, a low density insulating film (a low density cap film) **205** whose film density is 1.3 g/cm³ or lower is formed. In the nitrogen-containing insulating film **203** and (the lower portion of) the low dielectric constant film **204**, a via hole **206**, which reaches at least one of the lower-level metal interconnects **202**, is formed. In (the upper portion of) the low dielectric constant film **204** and the low density cap film **205**, a trench for wiring **207**, which is connected with the via hole **206**, is formed. In the via hole **206** and the trench **207**, a tantalum-nitride/tantalum multilayer film **208** and a copper film **209** are formed in sequence to form a via plug **210** and upper-level metal interconnects **211**.

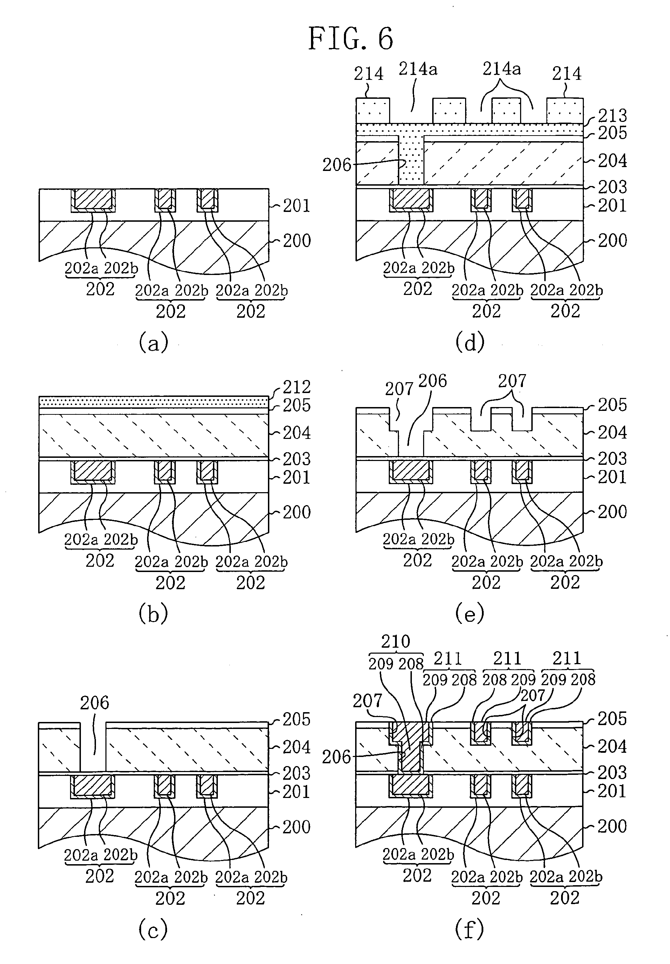

**FIGS. 6(a)** through **6(f)** are cross sectional views indicating process steps of a method for fabricating the electronic device according to the second embodiment, that is, a method for fabricating the electronic device shown in FIG. **5**.

First, as shown in FIG. **6(a)**, a lower-level insulating film **201** made of, e.g., a silicon oxide film is formed on a substrate **200** made of, e.g., silicon, after which lower-level metal interconnects **202**, made of, e.g., a tantalum-nitride/tantalum multilayer film 202a and a copper film **202b**, are buried in the lower-level insulating film **201**.

Subsequently, as shown in FIG. **6(b)**, a nitrogen-containing insulating film **203** made of, e.g., a silicon carbon nitride film or a silicon nitride film is deposited to a thickness of 50 nm on the lower-level insulating film **201** and the lower-level metal interconnects **202.** Thereafter, a low dielectric constant film **204** made of, e.g., a carbon-containing silicon oxide film is deposited to a thickness of 450 nm on the nitrogen-containing insulating film **203.** Subsequently, on the low dielectric constant film **204,** a low density cap film **205** whose film density is 1.3 g/cm³ or lower and whose thickness is 50 nm is formed. Thereafter, an organic material, for example, is applied onto the low density cap film **205** to form a first anti-reflection film **212**.

Next, a photoresist is applied onto the first anti-reflection film **212** and a photolithography process is performed on the photoresist, thereby forming a resist film (not shown) having a hole pattern. Thereafter, with the resist film used as a mask, the first anti-reflection film **212**, the low density cap film **205** and the low dielectric constant film **204** are sequentially dry-etched, and the photoresist and the first anti-reflection film **212** are then removed by ashing. By these steps, a via hole **206** is formed, as shown in FIG. **6(c).**

Subsequently, as shown in FIG. **6(d)**, an organic material, for example, is applied onto the low density cap film **205** so that the via hole **206** is filled completely, thereby forming a second anti-reflection film **213**. Thereafter, a photoresist is applied onto the second anti-reflection film **213**, and a photolithography (exposure and development) process is performed on the photoresist, thereby forming a resist film **214** having a desired trench pattern. More specifically, the resist film **214** having openings **214a** that correspond to a trench for wiring **207** (see FIG. **6(e)**) is formed. The regions in which the openings **214a** are formed include the region in which the via hole **206** is formed.

Next, with the resist film **214** having the trench pattern used as a mask, the second anti-reflection film **213,** the low density cap film **205,** and (the upper portion of) the low dielectric constant film **204** are dry-etched in sequence, thereby forming the trench **207**, which is connected with the via hole **206**, as shown in FIG. **6(e)**. It should be noted that after the dry-etching process, the remaining second anti-reflection film **213** and the resist film **214** are removed and a cleaning process is performed.

Subsequently, part of the nitrogen-containing insulating film **203** formed of the silicon carbon nitride film, which is located under the via hole **206**, is removed by performing an etchback process on the entire surface of the substrate. Thereafter, a tantalum-nitride/tantalum multilayer film **208** and a copper film **209** are deposited in sequence on the low density cap film **205** so that the via hole **206** and the trench **207** are filled completely. The multilayer film **208** and the copper film **209** are then removed by a CMP process where they are located externally of the trench **207.** By these steps, as shown in FIG. **6(f),** a via plug **210** is formed in the via hole **206,** while upper-level metal interconnects **211** are formed in the trench **207**. It should be noted that since the low density cap film **205** does not necessarily have to be left finally, this film may be completely or partially removed by the above-mentioned etchback process or CMP process.

As described above, in the second embodiment, the low density cap film **205** is formed on the low dielectric constant film (i.e., the carbon-containing silicon oxide film) **204**. Thus, nitrogen taken into the low dielectric constant film **204**, nitrogen within the nitrogen-containing insulating film **203**, and nitrogen present in the low density cap film **205** itself are likely to be released externally through the low density cap film **205**. This prevents an amine or the like from diffusing only into the via hole **206** formed in the low dielectric constant film **204**. Accordingly, the amount of the amine or the like present per unit volume of the resist where the resist is located near the via hole **206** is reduced significantly in the lithography process for forming the trench **207**, which results in the prevention of resist poisoning.

In the second embodiment, the effects mentioned above allow resist poisoning to be suppressed, while permitting the formation of the nitrogen-containing insulating film **203** (e.g., a silicon carbon nitride film) with excellent film quality under the low dielectric constant film **204**. It is thus possible to prevent leakage current increase or film quality changes with time. Moreover, since the silicon carbon nitride film, serving as the nitrogen-containing insulating film **203**, does not contain oxygen, the copper films **202b** are not oxidized when the nitrogen-containing insulating film **203** is deposited on the copper films **202b** that form the lower-level metal interconnects **202**.

Also, in the second embodiment, the nitrogen-containing insulating film **203** is left under the via hole **206**, that is, on the lower-level metal interconnects **202**, until the formation of the trench **207** is completed. This reduces damage (e.g., oxidation of the surfaces of the lower-level metal interconnects **202**) to the lower-level metal interconnects **202**, caused by the etching and ashing processes.

Furthermore, in the second embodiment, the second anti-reflection film **213** is buried in the via hole **206**, before the photolithography process for forming the trench **207** is performed. The second anti-reflection film **213** thus covers the wall surface of the via hole **206**. In other words, a damage layer in the wall surface of the via hole **206** is covered by the second anti-reflection film **213**. As a result, nitrogen diffusion from the damage layer into the via hole **206** is suppressed, thereby preventing resist poisoning more reliably.

Moreover, in the second embodiment, the kind of insulating film usable as the low density cap film **205** is not limited particularly, so long as the film employed has a film density of 1.3 g/cm³ or lower. However, if a film that has not only a low density but also a low dielectric constant, for example, a porous film, is used as the low density cap film **205**, capacitance between the interconnects is reduced. More specifically, a porous film, such as a HSQ (hydrogen silsesquioxane) film or a XLK film (whose density is about 0.9 g/cm³) fabricated by Dow Corning, may be used. If the low density cap film **205** contains nitrogen, the film quality of the low density cap film **205** is improved, so that leakage current increase or film quality changes with time is prevented. On the other hand, it is preferable that the low density cap film **205** does not contain carbon. This is because when a carbon-containing film such as a SiOC film is subjected to an ashing process, carbon is eliminated from the film, causing leakage current to flow easily. It should be noted that the density of the low density cap film **205** is preferably 0.4 g/cm³ or higher in consideration of the stability of the film.

In the second embodiment, in cases where a coating film, for example, a porous film such as the above-mentioned HSQ film, is used as the low density cap film **205**, it is preferable that after the formation of the low density cap film **205**, the low density cap film **205** be subjected to, e.g., a heat treatment at about 300 to 400 C°, or an EB (electron beam) cure process or a DUV (deep ultraviolet) cure process. Then, the quality of the low density cap film **205** is stabilized, while a greater amount of nitrogen is released externally through the low density cap film **205** from the nitrogen-containing insulating film **203**, the low dielectric constant film **204**, and the low density cap film **205**. It should be noted that instead of the EB and the DUV, light or an energy wave, which is other than DUV and capable of stabilizing the film quality of the low density cap film **205**, may be applied to the low density cap film **205**.

Also, in the second embodiment, a carbon-containing silicon oxide film such as a SiOC film, a Silk film, or a porous film such as a MSQ (methyl silsesquioxane) film, for example, may be used as the low dielectric constant film **204**.

Furthermore, in the second embodiment, although the present invention is applied to form the interconnection structure including the lower-level metal interconnects **202** and the upper-level metal interconnects **211** that are connected with each other by the via plug **210**, the present invention is not limited to this. It will be obvious that the present invention is applicable to, for example, formation of a memory cell structure including a transistor (i.e., doped layers thereof) and a capacitor (i.e., a lower electrode thereof) that are connected with each other by a contact plug.

### INDUSTRIAL APPLICABILITY

The present invention relates to electronic devices and methods for fabricating the devices, and when applied to, e.g., formation of a multilevel interconnection structure, the present invention achieves the outstanding effect of preventing resist poisoning in lithography process steps.

## Claims

1. An electronic device comprising:
a low dielectric constant film having a hole,
a nitrogen-non-containing insulating film formed under the low dielectric constant film, and
a nitrogen-containing insulating film formed under the nitrogen-non-containing insulating film.

2. The electronic device of Claim 1, wherein
the hole passes through the nitrogen-non-containing insulating film and the nitrogen-containing insulating film,
the electronic device further includes a lower-level interconnect which is located under the hole and connected with the hole, and
the upper surface of the lower-level interconnect, except for a region in which the lower-level interconnect is connected with the hole, is covered with the nitrogen-containing insulating film.

3. The electronic device of Claim 1, wherein the lower surface of the low dielectric constant film is in contact with the upper surface of the nitrogen-non-containing insulating film.

4. The electronic device of Claim 1, wherein the low dielectric constant film is a carbon-containing silicon oxide film or a porous film.

5. The electronic device of Claim 4, wherein the carbon-containing silicon oxide film is a SiOC film.

6. An electronic device comprising:
a low dielectric constant film having a hole,
a nitrogen-non-containing insulating film formed over the low dielectric constant film, and
a nitrogen-containing insulating film formed over the nitrogen-non-containing insulating film.

7. The electronic device of Claim 6, wherein the nitrogen-containing insulating film is an anti-reflection film, and
a trench, which is connected with the hole, is formed in the nitrogen-containing insulating film, the nitrogen-non-containing insulating film, and at least an upper portion of the low dielectric constant film.

8. The electronic device of Claim 6, wherein the upper surface of the low dielectric constant film is in contact with the lower surface of the nitrogen-non-containing insulating film.

9. The electronic device of Claim 6, wherein the low dielectric constant film is a carbon-containing silicon oxide film or a porous film.

10. The electronic device of Claim 9, wherein the carbon-containing silicon oxide film is a SiOC film.

11. An electronic device comprising:
a low dielectric constant film having a hole,
a first nitrogen-non-containing insulating film formed under the low dielectric constant film, and
a second nitrogen-non-containing insulating film formed over the low dielectric constant film,
wherein the hole passes through the first nitrogen-non-containing insulating film, and
a trench, which is connected with the hole, is formed in the second nitrogen-non-containing insulating film and at least an upper portion of the low dielectric constant film.

12. The electronic device of Claim 11, wherein the lower surface of the low dielectric constant film is in contact with the upper surface of the first nitrogen-non-containing insulating film.

13. The electronic device of Claim 11, wherein the upper surface of the low dielectric constant film is in contact with the lower surface of the second nitrogen-non-containing insulating film.

14. The electronic device of Claim 11, wherein the low dielectric constant film is a carbon-containing silicon oxide film or a porous film.

15. The electronic device of Claim 14, wherein the carbon-containing silicon oxide film is a SiOC film.

16. An electronic device comprising:
a low dielectric constant film having a hole, and
a low density insulating film having a film density of 1.3 g/cm³ or lower and formed over the low dielectric constant film.

17. The electronic device of Claim 16, wherein the low density insulating film contains nitrogen.

18. The electronic device of Claim 16, further comprising a nitrogen-containing insulating film formed under the low dielectric constant film.

19. The electronic device of Claim 16, wherein the low dielectric constant film is a carbon-containing silicon oxide film or a porous film.

20. The electronic device of Claim 19, wherein the carbon-containing silicon oxide film is a SiOC film.

21. A method for fabricating an electronic device comprising:
the step of forming a nitrogen-non-containing insulating film and a low dielectric constant film in sequence over a nitrogen-containing insulating film;
the step of forming a hole in the low dielectric constant film;
the step of applying a chemically amplified resist on the low dielectric constant film with the hole formed therein, and subjecting the chemically amplified resist to exposure and development processes, thereby forming a resist film having an opening in a predetermined region that includes a region in which the hole is formed; and
the step of etching the low dielectric constant film with the resist film used as a mask, thereby forming a trench which is connected with the hole.

22. The method of Claim 21, wherein the nitrogen-containing insulating film is formed so as to cover a lower-level interconnect.

23. The method of Claim 21, wherein the hole-forming step includes the step of forming the hole in the low dielectric constant film and the nitrogen-non-containing insulating film, and
the method further includes, after the trench-forming step, the step of removing part of the nitrogen-containing insulating film which is located under the hole.

24. The method of Claim 21, wherein the nitrogen-non-containing insulating film is deposited by a CVD process.

25. The method of Claim 21, further comprising, between the hole-forming step and the resist-film forming step, the step of forming a dummy plug in the hole.

26. The method of Claim 21, wherein the low dielectric constant film is a carbon-containing silicon oxide film or a porous film.

27. The method of Claim 26, wherein the carbon-containing silicon oxide film is a SiOC film.

28. A method for fabricating an electronic device comprising:
the step of forming a nitrogen-non-containing insulating film and a nitrogen-containing insulating film in sequence over a low dielectric constant film;
the step of forming a hole in the low dielectric constant film with the nitrogen-non-containing insulating film and the nitrogen-containing insulating film formed thereon;
the step of applying a chemically amplified resist over the low dielectric constant film with the hole formed therein, and subjecting the chemically amplified resist to exposure and development processes, thereby forming a resist film having an opening in a predetermined region that includes a region in which the hole is formed; and
the step of etching the low dielectric constant film with the resist film used as a mask, thereby forming a trench which is connected with the hole.

29. The method of Claim 28, wherein the nitrogen-containing insulating film functions as an anti-reflection film in the resist-film forming step.

30. The method of Claim 28, wherein the nitrogen-non-containing insulating film is deposited by a CVD process.

31. The method of Claim 28, further comprising, between the hole-forming step and the resist-film forming step, the step of forming a dummy plug in the hole.

32. The method of Claim 28, wherein the low dielectric constant film is a carbon-containing silicon oxide film or a porous film.

33. The method of Claim 32, wherein the carbon-containing silicon oxide film is a SiOC film.

34. A method for fabricating an electronic device comprising:
the step of forming a low dielectric constant film and a second nitrogen-non-containing insulating film in sequence over a first nitrogen-non-containing insulating film;
the step of forming a hole in the low dielectric constant film with the second nitrogen-non-containing insulating film formed thereon;
the step of applying a chemically amplified resist over the low dielectric constant film with the hole formed therein, and subjecting the chemically amplified resist to exposure and development processes, thereby forming a resist film having an opening in a predetermined region that includes a region in which the hole is formed; and
the step of etching the low dielectric constant film with the resist film used as a mask, thereby forming a trench which is connected with the hole.

35. The method of Claim 34, wherein the first and second nitrogen-non-containing insulating films are deposited by a CVD process.

36. The method of Claim 34, further comprising, between the hole-forming step and the resist-film forming step, the step of forming a dummy plug in the hole.

37. The method of Claim 34, wherein the low dielectric constant film is a carbon-containing silicon oxide film or a porous film.

38. The method of Claim 37, wherein the carbon-containing silicon oxide film is a SiOC film.

39. A method for fabricating an electronic device comprising:
the step of forming a low density insulating film whose film density is 1.3 g/cm³ or lower on a low dielectric constant film;
the step of forming a hole in the low dielectric constant film with the low density insulating film formed thereon;
the step of applying a chemically amplified resist over the low dielectric constant film with the hole formed therein, and subjecting the chemically amplified resist to exposure and development processes, thereby forming a resist film having an opening in a predetermined region that includes a region in which the hole is formed; and
the step of etching the low dielectric constant film with the resist film used as a mask, thereby forming a trench which is connected with the hole.

40. The method of Claim 39, further comprising, after the low-density-insulating-film forming step, the step of subjecting the low density insulating film to a heat treatment or applying an energy wave to the low density insulating film.

41. The method of Claim 40, wherein the energy wave is an electron beam or ultraviolet radiation.

42. The method of Claim 39, wherein the low dielectric constant film is a carbon-containing silicon oxide film or a porous film.

43. The method of Claim 42, wherein the carbon-containing silicon oxide film is a SiOC film.
